# FASCICULE DE BREVET EUROPEEN

(11) **EP 2 938 582 B1**
(45) Date de publication et mention de la délivrance du brevet: **15.02.2017**
(21) Numéro de dépôt: 13821880.5
(22) Date de dépôt: 20.12.2013
(51) Int. Cl.: C03C 1/00, C03C 17/00, C04B 41/50, C04B 41/87, C03C 17/22

(54) **SUBSTRAT TRANSPARENT, NOTAMMENT SUBSTRAT VERRIER, REVÊTU PAR AU MOINS UNE COUCHE POREUSE AU MOINS BIFONCTIONNELLE, PROCÉDÉ DE FABRICATION ET APPLICATIONS**
TRANSPARENTES SUBSTRAT, INSBESONDERE GLASSUBSTRAT, BESCHICHTET MIT MINDESTENS EINER MINDESTENS BIFUNKTIONELLEN PORÖSEN SCHICHT, HERSTELLUNGSVERFAHREN UND VERWENDUNGEN DAVON
TRANSPARENT SUBSTRATE, IN PARTICULAR A GLASS SUBSTRATE, COATED WITH AT LEAST ONE AT LEAST BIFUNCTIONAL POROUS LAYER, MANUFACTURING METHOD AND USES THEREOF

(30) Priorité: 28.12.2012 FR 1262959
(43) Date de publication de la demande: 04.11.2015
(73) Titulaire: Saint-Gobain Glass France, 92400 Courbevoie (FR); Centre National de la Recherche Scientifique, 75794 Paris Cedex 16 (FR)
(72) Inventeur: BENAKLI, Anouchka, F-91400 Orsay (FR); BOURGEAT-LAMI, Elodie, F-01120 Nievroz (FR); GUILLEMOT, François, F-75019 Paris (FR)
(74) Mandataire: Saint-Gobain Recherche
(86) Numéro de dépôt international: PCT/FR2013/053219
(87) Numéro de publication internationale: WO 2014/102493

(56) Documents cités:
- WO-A1-2010/027854
- WO-A1-2010/069997
- CN-A- 102 430 372

## Description

La présente invention concerne un substrat transparent, notamment un substrat verrier, revêtu par au moins une couche poreuse au moins bifonctionnelle, un procédé de fabrication dudit substrat revêtu et son utilisation comme élément d'un dispositif opto-électronique ou d'un vitrage.

On connaît des vitrages destinés au marché photovoltaïque revêtus d'une couche à bas indice de réfraction (couche anti-reflet) déposée par voie liquide. Cette couche est élaborée suivant le procédé sol-gel à l'aide d'un précurseur de silice et de nanoparticules organiques (latex). Cette couche poreuse préparée de cette façon présente l'avantage d'être peu onéreuse et de présenter la très bonne performance optique anti-reflet recherchée ainsi qu'une stabilité de ces performances vis-à-vis de l'environnement (humidité de l'air, pollution).

La demande internationale PCT WO 2008/059170 A2 décrit la formation d'une telle couche poreuse, essentiellement minérale et de type sol-gel, présentant une série de pores fermés.

La demande de brevet français 2 974 800 A1 décrit un substrat transparent revêtu d'un empilement de couches dont une couche poreuse est recouverte d'au moins une autre couche. Les couches de cet empilement sont choisies pour leurs propriétés optiques et mécaniques particulières. On utilise par exemple des couches à indice de réfraction variable pour créer un gradient d'indice de réfraction.

Les supports revêtus d'au moins une couche poreuse de l'état antérieur de la technique donnent toute satisfaction. Cependant, il est apparu qu'ils pouvaient être perfectionnés en raison de différentes constations :
- les couches poreuses connues ont pour seule fonction d'être anti-reflet ; par exemple, si le substrat revêtu d'une telle couche poreuse anti-reflet est utilisé comme verre de recouvrement (« cover-glass ») pour panneau photovoltaïque, il peut facilement s'encrasser ; l'ajout de valeur sur les verres et vitrages ainsi revêtus d'un revêtement anti-reflet pourrait donc passer par l'ajout d'une seconde fonction au coeur de la couche, en particulier une fonction auto-nettoyante ou « facile à nettoyer » ; dans le cas précité du verre de recouvrement, un moindre encrassement permettrait d'améliorer les fonctions énergétiques du module ;
- les couches poreuses de silice sont dégradées lors du vieillissement de la couche par voie hydrolytique ; en particulier, la corrosion du substrat de verre peut donner lieu à une dissolution de la couche de silice, laquelle peut précipiter à nouveau sous la forme d'un couche peu dense de gel de silice ; l'ajout d'un autre matériau à la surface des pores pourrait apporter une solution à ce problème ;
- les propriétés mécaniques des matériaux poreux sont intrinsèquement moins bonnes que celles d'un matériau dense ; ceci se manifeste pour une couche poreuse anti-reflet par une résistance à la rayure peu élevée ; l'ajout d'un autre matériau dense au sein d'une couche poreuse de silice pourrait en améliorer les propriétés mécaniques.

La Société déposante a recherché une solution permettant de répondre à l'ensemble des problèmes évoqués ci-dessus afin de proposer une couche poreuse au moins bifonctionnelle, comportant en plus de la fonctionnalité de la couche poreuse en tant que telle, au moins une autre fonctionnalité, laquelle peut être de tout type, ce qui permet de proposer des substrats ayant différentes propriétés, lesquelles sont avantageusement ajustables et ce qui offre l'avantage complémentaire de permettre de construire des empilements de couches avec des propriétés diverses et ajustées selon l'application considérée.

A cet effet, selon l'invention, il est proposé de procéder à la fonctionnalisation de la surface de pores par l'utilisation d'un latex nanocomposite (parfois appelé ci-après latex composite). Un tel latex se présente sous la forme d'une dispersion de nanoparticules organiques revêtues en surface par une matière inorganique, notamment par des particules inorganiques, lesquelles peuvent être physisorbées (interaction électrostatique par exemple) ou chimisorbées à la surface des particules de polymère (liaison forte entre le matériau inorganique et le polymère), une telle morphologie de particules étant parfois désignée comme « morphologie de framboise ».

Un avantage supplémentaire d'une telle approche est que les pores ne sont pas remplis par un second matériau, lequel n'est ici déposé qu'à la surface des pores. Ainsi, lorsque ce second matériau est onéreux ou possède des propriétés optiques qui limiteront l'effet anti-reflet, on rend sa quantité minimale au sein de la couche tout en bénéficiant de ses propriétés de surface.

La présente invention a donc d'abord pour objet un substrat transparent en verre ou en céramique ou en vitrocéramique, revêtu par une couche fonctionnelle ou par un empilement d'au moins deux couches fonctionnelles, ladite couche fonctionnelle ou au moins l'une desdites couches fonctionnelles de l'empilement étant poreuse et faite d'un matériau inorganique M1, caractérisé par le fait que la ou au moins l'une des couches fonctionnelles poreuses de matériau inorganique M1 présente, à la surface d'au moins une partie de ses pores, au moins un matériau inorganique M2 différent de M1.

Par l'expression « matériau inorganique M2 différent de M1 », on englobe les matériaux de même nature chimique mais qui peuvent se présenter sous des formes physiques différentes, telle qu'une silice moins dense et une silice plus dense.

Le matériau inorganique M2 est avantageusement présent à la surface de tous les pores d'une couche poreuse de matériau inorganique M1.

Le matériau inorganique M1 peut avantageusement être un matériau résultant du durcissement d'une solution sol-gel d'au moins un précurseur d'oxyde métallique et/ou d'au moins un organosilane de formule générale :

RₙSiX₄₋ₙ,

dans laquelle :
- n est égal à 0, 1, 2 ou 3, de préférence est égal à 0 ou 1 ;
- les groupes X, identiques ou différents lorsque n est égal à 0, 1 ou 2, représentent des groupes hydrolysables choisis parmi les groupes alcoxy, acyloxy ou halogénure, de préférence alcoxy ; et
- les groupes R, identiques ou différents lorsque n est égal à 2 ou 3, représentent des groupes organiques ou fonctions organiques non hydrolysables lié(e)s au silicium par un atome de carbone,
   ledit ou lesdits précurseurs d'oxyde métallique et ledit ou lesdits organosilanes ayant subi une hydrolyse et une condensation pendant ledit durcissement.

En particulier, un précurseur d'oxyde métallique peut être un précurseur d'un oxyde d'un métal choisi parmi Si, Ti, Zr, Al, Zn, Sn, Nb, Sb.

Les groupes X peuvent avantageusement être choisis parmi les groupes alcoxy -O-R', avec R' représentant un groupe alkyle en C₁-C₄, notamment méthoxy ou éthoxy, les groupes acyloxy -O-C(O)R", avec R" représentant un radical alkyle, tel qu'un alkyle en C₁-C₆, notamment méthyle ou éthyle ; les halogénures tels que Cl, Br et I ; et leurs combinaisons.

Les groupes R peuvent avantageusement être choisis parmi les groupes méthyle, glycidyle ou glycidoxypropyle.

Les pores peuvent par exemple représenter 5 à 74 % en volume d'une couche poreuse de matériau inorganique M1.

Les pores d'une couche poreuse peuvent être de forme sphérique ou ovoïde.

Le matériau inorganique M2 peut avantageusement se présenter sous la forme de nanoparticules adsorbées à la surface des pores du matériau inorganique M1.

Le matériau inorganique M2 peut aussi se présenter sous la forme d'une coquille sur toute la surface intérieure des pores.

Le matériau inorganique M2 est avantageusement issu d'une phase inorganique dispersable sous la forme de nanoparticules dans l'eau et adsorbable à la surface de particules d'un latex dit latex de base, notamment par hétérocoagulation et avantageusement sous agitation par ultrasons.

Les nanoparticules du matériau M2 peuvent être des nanoparticules catalytiques, telles que photocatalytiques et thermocatalytiques, ou des particules luminescentes.

Le matériau M2 peut être à base d'au moins un oxyde métallique, tel qu'un oxyde de Si, Ti, Zr, Al, Zn, Sn, Nb, Sb, Ce, ou d'un vanadate contenant des ions des lanthanides.

La couche de matériau M1 peut avoir une épaisseur de 50 nm à 5 µm, de préférence de 100 nm à 2 µm et que les pores qu'elle contient présentent une plus grande dimension moyenne de 30 à 600 nm.

Dans le cas de nanoparticules adsorbées à la surface des pores du matériau M1, celles-ci peuvent avoir une dimension de 5 à 100 nm.

Dans le cas où le matériau inorganique M2 se présente sous la forme d'une coquille sur toute la surface intérieure des pores, cette coquille peut avoir une épaisseur de 2 à 50 nm.

Conformément à un mode de réalisation plus particulier, le matériau M1 est issu d'un précurseur de SiO₂ hydrolyse et le matériau M2 est TiO₂, la couche poreuse étant une couche anti-reflet à bas indice de réfraction et présentant une fonctionnalité auto-nettoyante.

Dans un mode de réalisation particulier, le substrat revêtu selon l'invention comporte un empilement de couches fonctionnelles dont fait ou font partie la ou les couches fonctionnelles poreuses de matériau inorganique M1 présentant, à la surface d'au moins une partie de ses pores, au moins un matériau inorganique M2 différent de M1, la ou les couches fonctionnelles autres que la ou les couches fonctionnelles poreuses précitées ayant été déposées par voie liquide ou par pulvérisation cathodique, telle que PVD, CVD, ou par pyrolyse liquide.

La présente invention porte également sur un procédé de fabrication d'un substrat revêtu tel que défini ci-dessus, caractérisé par le fait que, sur un substrat en verre ou en céramique ou en vitrocéramique, on dépose par voie liquide au moins une couche d'un mélange aqueux de précurseur de matériau inorganique M1 et d'un latex aqueux composite dont les particules sont constituées chacune par un coeur organique présentant en surface un matériau M2, et que l'on chauffe jusqu'à élimination ou élimination substantielle des coeurs organiques et de l'eau présente dans le mélange de précurseur et de latex composite.

On utilise avantageusement, comme précurseur de matériau inorganique M1, une solution sol-gel d'au moins un précurseur d'oxyde métallique et/ou d'au moins un organosilane de formule générale :

RₙSiX₄₋ₙ,

dans laquelle :
- n est égal à 0, 1, 2 ou 3, de préférence est égal à 0 ou 1 ;
- les groupes X, identiques ou différents lorsque n est égal à 0, 1 ou 2, représentent des groupes hydrolysables choisis parmi les groupes alcoxy, acyloxy ou halogénure, de préférence alcoxy ; et
- les groupes R, identiques ou différents lorsque n est égal à 2 ou 3, représentent des groupes organiques ou fonctions organiques non hydrolysables lié(e)s au silicium par un atome de carbone,
   le matériau inorganique M1 étant obtenu par durcissement de ladite solution sol-gel, au cours duquel ledit ou lesdits précurseurs d'oxyde métallique et ledit ou lesdits organosilanes subissent une hydrolyse et une condensation.

Un précurseur d'oxyde métallique peut être un précurseur d'un oxyde d'un métal choisi parmi Si, Ti, Zr, Al, Zn, Sn, Nb, Sb.

Les groupes X peuvent être choisis parmi les groupes alcoxy -O-R', avec R' représentant un groupe alkyle en C₁-C₄, notamment méthoxy ou éthoxy, les groupes acyloxy -O-C(O)R", avec R" représentant un radical alkyle, tel qu'un alkyle en C₁-C₆, notamment méthyle ou éthyle ; les halogénures tels que Cl, Br et I ; et leurs combinaisons.

Les groupes R peuvent être choisis parmi les groupes méthyle, glycidyle ou glycidoxypropyle.

Dans un mode de réalisation particulier, on utilise le tétraéthoxysilane (TEOS) comme précurseur de matériau inorganique M1.

Conformément à un mode de réalisation particulièrement avantageux, on prépare le latex aqueux composite en mélangeant un latex dit de base obtenu par polymérisation en émulsion aqueuse d'un polymère ou copolymère P avec une dispersion dans l'eau de nanoparticules de matériau organique M2 dans des conditions d'hétérocoagulation et, avantageusement sous agitation par ultrasons, pour obtenir un latex dit nanocomposite, dont les particules de polymère ou copolymère P constituant lesdits coeurs organiques portent en surface lesdites nanoparticules de matériau M2.

L'hétérocoagulation et l'agitation par ultrasons conduisent à une dispersion stable des particules de polymère revêtues des nanoparticules.

Dans le cas où le matériau inorganique M2 se présente sous la forme d'une coquille sur toute la surface intérieure des pores d'une couche poreuse, on peut préparer le latex aqueux composite en mélangeant un latex dit de base obtenu par polymérisation en émulsion aqueuse d'un polymère ou copolymère P avec un précurseur de matériau inorganique M2 en solution, et en ajustant les conditions de réaction pour qu'une réaction de condensation se produise sur toute la surface des particules du latex de base, formant un enrobage desdites particules par le matériau inorganique M2.

On peut choisir le polymère ou copolymère P parmi le poly(méthacrylate de méthyle), les copolymères méthacrylate de méthyle-acrylate de butyle et le polystyrène.

On peut utiliser avantageusement un matériau M2 à base d'au moins un oxyde métallique, tel qu'un oxyde de Si, Ti, Zr, Al, Zn, Sn, Nb, Sb, Ce, ou d'un vanadate contenant des ions des lanthanides.

On peut déposer la couche de mélange par revêtement par centrifugation.

Pour former un empilement de couches, on dépose avantageusement au moins une autre couche fonctionnelle par voie liquide ou par pulvérisation cathodique, telle que PVD, CVD, ou par pyrolyse liquide, dans l'ordre désiré pour l'empilement de couches.

La présente invention a également pour objet l'utilisation du substrat revêtu tel que défini ci-dessus ou fabriqué par le procédé tel que défini ci-dessus comme élément d'un dispositif opto-électronique, tel que module photovoltaïque et dispositif électroluminescent, ou d'un vitrage monolithique ou feuilleté, simple ou multiple, pour le bâtiment et les véhicules de transport.

La présente invention a également pour objet un module photovoltaïque comportant un substrat revêtu tel que défini ci-dessus ou fabriqué par le procédé tel que défini ci-dessus comme verre de recouvrement.

La présente invention a également pour objet un dispositif électroluminescent comportant un substrat revêtu tel que défini ci-dessus ou fabriqué par le procédé tel que défini ci-dessus comme diode organique électroluminescente (OLED).

La présente invention a également pour objet un vitrage monolithique ou feuilleté, simple ou multiple, pour le bâtiment et les véhicules de transport, comportant au moins un substrat revêtu tel que défini ci-dessus ou fabriqué par le procédé tel que défini ci-dessus comme vitre ou feuille de verre d'un vitrage multiple.

Les exemples suivants illustrent la présente invention sas toutefois en limiter la portée.

### Exemple 1 : Préparation d'un sol de précurseur de silice hydrolyse (appelé sol de silice)

Dans un ballon, on a introduit 14,2mL (nSi = nombres de moles de précurseur de silice = 6,4.10⁻² mol) de tétraéthoxysilane (TEOS), 11,2mL d'éthanol (3nSi mol d'éthanol) et 4,62mL d'une solution d'acide chlorhydrique dans de l'eau désionisée dont le pH vaut 2.5 (4nSi mol d'eau). On a porté le mélange à 60°C pendant 60 min sous agitation. L'objectif était alors de préparer une solution contenant le précurseur de silice à 2,90 mol/L dans l'eau, en ayant éliminé autant d'éthanol que possible. Pour obtenir la concentration désirée, le volume final de solution devait être de 22 mL.

Après la première étape, le sol contenait 7nSi mol d'éthanol (éthanol initial, plus éthanol libéré par l'hydrolyse), ce qui correspondait à un volume de 26 mL (la densité de l'éthanol vaut 0,79).

Au sol issu de la première étape, on a ajouté 20 mL de solution d'acide chlorhydrique dont le pH vaut 2,5. On a porté le mélange sous vide et on l'a chauffé légèrement dans un évaporateur rotatif afin d'en retirer l'éthanol.

Après cette étape, on a ajouté le volume de solution à 22 mL avec de la solution d'acide chlorhydrique dont le pH vaut 2,5 et le sol de silice était prêt.

### Exemple 2 : Préparation d'un latex de base

Dans un réacteur à double enveloppe de 500 mL, thermostaté à 70°C, équipé d'un agitateur mécanique, d'un réfrigérant et d'une arrivée pour bullage d'azote, on a introduit 151 g d'eau désionisée (résistivité > 16M) et deux tensio-actifs : 0,45 g de TERGITOL™ NP-30 (Dow Chemical) et 0,02g de dodécylsulfate de sodium.

En parallèle, on a placé les monomères : 24 g de méthacrylate de méthyle (MMA, 99 %, Aldrich) et 6.1 g d'acrylate de butyle (ABu, Aldrich) d'une part, et l'amorceur : 0,3 g de persulfate de sodium dilué dans un peu d'eau (prélevée sur les 151 g), d'autre part, dans des flacons séparés équipés de bouchons à jupe.

Le contenu du réacteur ainsi que celui des deux flacons ont été désaérés pendant 15 min par bullage d'azote.

Les monomères et l'amorceur de polymérisation ont ensuite été introduits en une fois dans le réacteur sous agitation mécanique (250 tours/minute). Toute la réaction s'est poursuivie réacteur fermé, avec le courant d'azote maintenu juste au-dessus du milieu réactionnel. Le milieu réactionnel s'est troublé rapidement après l'ajout des monomères en raison de la formation de gouttelettes de monomères. Après quelques minutes, le milieu a pris une coloration blanche, signe de la diffusion de la lumière par les particules déjà formées. La polymérisation a été poursuivie pendant deux heures, et le réacteur a été vidangé. La conversion atteinte était de 99,1%.

Le latex a été caractérisé par diffusion dynamique de la lumière (*Particle size analysis - Photon correlation spectroscopy 13321:1996*, *International Standards Organization*) et mesure de potentiel zêta sur un appareil ZetaSizer commercialisé par la société Malvern. Ainsi, le diamètre moyen des objets mesurés est de 230 nm et l'indice de polydispersité vaut 0,016. Le potentiel zêta est mesuré à -31,8 mV.

### Exemple 3 : Préparation d'un latex nanocomposite par hétérocoagulation

A 10 g du latex préalablement préparé et placé dans un bain à ultrasons, on a ajouté des nanoparticules de TiO₂ par addition au 5,7 g d'une dispersion aqueuse de ces nanoparticules.

La dispersion des particules de TiO₂ utilisée était le produit commercialisé par la Société Cristal Global sous la référence SA-300A correspondant à une dispersion aqueuse stable de particules de TiO₂ à 23% en masse par rapport à la masse totale de la dispersion, présentant une surface spécifique BET d'environ 330 m²/g et un diamètre moyen de l'ordre de 50 nm.

L'utilisation d'un bain à ultrasons a permis de limiter le phénomène de floculation observé lorsque qu'une goutte de nanoparticules de TiO₂ est ajoutée à la suspension de latex. Cette déstabilisation immédiate est liée à une interaction électrostatique très forte entre les particules de TiO₂ et les particules polymères.

### Exemples 4A à 4D : Préparation des mélanges sol de silice de l'Exemple 1 - latex nanocomposite de l'Exemple 3

On a réalisé quatre mélanges du sol de silice de l'Exemple 1 avec le latex nanocomposite de l'Exemple 3 dans les proportions indiquées dans le Tableau 1 suivant.

**Tableau 1**

| Exemple | 4A | 4B | 4C | 4D |
|---|---|---|---|---|
| Masse de sol de silice (g) | 1, 79 | 1,61 | 1,44 | 1,25 |
| Masse de latex nanocomposite (g) | 0,16 | 0,32 | 0, 49 | 0,66 |
| Masse de solution d'HCl à pH=2 (g) | 0,06 | 0,07 | 0,08 | 0,09 |
| Porosité (%) | 10 | 20 | 30 | 40 |

### Exemples 5A à 5D : Formation des couches poreuses selon l'invention

On a déposé à la pipette Pasteur chacun des mélanges des Exemples 4A à 4D sur toute la surface d'une plaque de verre fixée sur un support horizontal rotatif et on a fait tourner le support à 2000 tours/min pendant 60 s jusqu'à obtention d'une couche uniforme (technique de revêtement par centrifugation « spin-coating »).

Chacune des couches a ensuite été calcinée à 450°C pendant une heure trente.

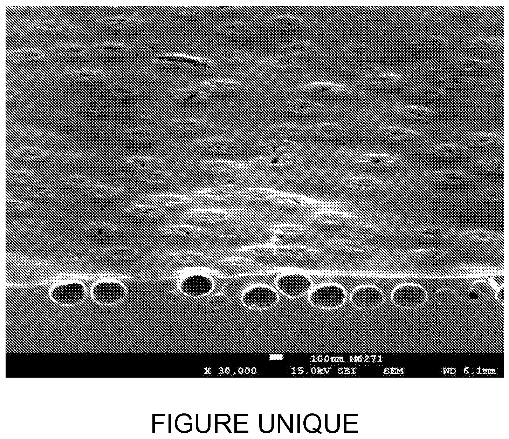

Des images de microscopie électronique à balayage (MEB) des couches poreuses ont été prises et l'on a observé sur ces clichés la morphologie souhaitée des pores tapissés de nanoparticules de TiO₂. La Figure unique du dessin annexé montre un cliché MEB de la couche poreuse correspondant à l'Exemple 5C.

On a mesuré l'indice de réfraction à 600 nm de chacune de ces couches par ellipsométrie et leur réflectivité à 600 nm par spectroscopie UV-Visible.

Les résultats sont rapportés dans le Tableau 2 ci-après.

**Tableau 2**

| Couche de l'Exemple | 5A | 5B | 5C | 5D |
|---|---|---|---|---|
| Indice de réfraction à 600 nm | 1,430 | 1,395 | 1,378 | 1,345 |
| Réflectivité à 600nm | NA | 5% | 4% | 3% |

On remarque que la réflectivité des substrats revêtus peut être plus faible que celle du verre de base (4%).

Le diagramme de mesure de l'indice de réfraction que l'on peut tracer en fonction des porosités en utilisant les porosités données dans le Tableau 1 et les indices de réfraction donnés dans le Tableau 2 montre une droite, indiquant par là qu'il est simple d'ajuster l'indice de réfraction et montrant la conformité au modèle de milieu effectif de Brüggeman.

### Exemple 6 : Test photocatalytique

Pour évaluer l'activité photocatalytique des couches poreuses dans les UV-A, on a procédé à un test de photodégradation de l'acide stéarique.

Ce test consiste à déposer par centrifugation (« spin coating ») sur les couches une certaine quantité d'acide stéarique, utilisé en tant que polluant de la couche, puis de suivre l'évolution de sa concentration, par spectroscopie IR en transmission, après dépôt, puis au cours de l'exposition aux UV dans la gamme 315-400 nm.

Le spectre infrarouge en transmission est retraité par soustraction du spectre de l'échantillon obtenu avant déposition de l'acide stéarique. Par la suite, on obtient le spectre d'absorbance, à partir de l'inverse du spectre de transmittance, centré sur la région 2825-2950 cm⁻¹. On observe sur le spectre d'absorption une diminution de l'intensité des bandes de vibrations caractéristiques de l'acide stéarique, au fur et à mesure de l'exposition de l'échantillon aux UV-A.

Avec ce test, la couche de l'Exemple 5A a dégradé 18% de la quantité d'acide stéarique déposée sous irradiation UV-A pendant 150 min.

## Revendications

1. Substrat transparent en verre ou en céramique ou en vitrocéramique, revêtu par une couche fonctionnelle ou par un empilement d'au moins deux couches fonctionnelles, ladite couche fonctionnelle ou au moins l'une desdites couches fonctionnelles de l'empilement étant poreuse et faite d'un matériau inorganique M1, **caractérisé par le fait que** la ou au moins l'une des couches fonctionnelles poreuses de matériau inorganique M1 présente, à la surface d'au moins une partie de ses pores, au moins un matériau inorganique M2 différent de M1.

2. Substrat revêtu selon la revendication 1, **caractérisé par le fait que** le matériau inorganique M2 est présent à la surface de tous les pores d'une couche poreuse de matériau inorganique M1.

3. Substrat revêtu selon l'une des revendications 1 et 2, **caractérisé par le fait que** le matériau inorganique M1 est un matériau résultant du durcissement d'une solution sol-gel d'au moins un précurseur d'oxyde métallique et/ou d'au moins un organosilane de formule générale :
RₙSiX₄₋ₙ,
dans laquelle :
- n est égal à 0, 1, 2 ou 3, de préférence est égal à 0 ou 1 ;
- les groupes X, identiques ou différents lorsque n est égal à 0, 1 ou 2, représentent des groupes hydrolysables choisis parmi les groupes alcoxy, acyloxy ou halogénure, de préférence alcoxy ; et
- les groupes R, identiques ou différents lorsque n est égal à 2 ou 3, représentent des groupes organiques ou fonctions organiques non hydrolysables lié(e)s au silicium par un atome de carbone,
ledit ou lesdits précurseurs d'oxyde métallique et ledit ou lesdits organosilanes ayant subi une hydrolyse et une condensation pendant ledit durcissement.

4. Substrat revêtu selon la revendication 3, **caractérisé par le fait qu'**un précurseur d'oxyde métallique est un précurseur d'un oxyde d'un métal choisi parmi Si, Ti, Zr, Al, Zn, Sn, Nb, Sb.

5. Substrat revêtu selon la revendication 3, **caractérisé par le fait que** les groupes X sont choisis parmi les groupes alcoxy -O-R', avec R' représentant un groupe alkyle en C₁-C₄, notamment méthoxy ou éthoxy, les groupes acyloxy -O-C(O)R", avec R" représentant un radical alkyle, tel qu'un alkyle en C₁-C₆, notamment méthyle ou éthyle ; les halogénures tels que Cl, Br et I ; et leurs combinaisons.

6. Substrat revêtu selon la revendication 3, **caractérisé par le fait que** les groupes R sont choisis parmi les groupes méthyle, glycidyle ou glycidoxypropyle.

7. Substrat revêtu selon l'une des revendications 1 à 6, **caractérisé par le fait que** les pores représentent 5 à 74 % en volume d'une couche poreuse de matériau inorganique M1.

8. Substrat revêtu selon l'une des revendications 1 à 7, **caractérisé par le fait que** les pores sont de forme sphérique ou ovoïde.

9. Substrat revêtu selon l'une des revendications 1 à 8, **caractérisé par le fait que** le matériau inorganique M2 se présente sous la forme de nanoparticules adsorbées à la surface des pores du matériau inorganique M1.

10. Substrat revêtu selon l'une des revendications 1 à 8, **caractérisé par le fait que** le matériau inorganique M2 se présente sous la forme d'une coquille sur toute la surface intérieure des pores.

11. Substrat revêtu selon l'une des revendications 1 à 10, **caractérisé par le fait que** le matériau inorganique M2 est issu d'une phase inorganique dispersable sous la forme de nanoparticules dans l'eau et adsorbable à la surface de particules d'un latex dit latex de base, notamment par hétérocoagulation et avantageusement sous agitation par ultrasons.

12. Substrat revêtu selon l'une des revendications 1 à 11, **caractérisé par le fait que** les nanoparticules du matériau M2 sont des nanoparticules catalytiques, telles que photocatalytiques et thermocatalytiques, ou des particules luminescentes.

13. Substrat revêtu selon l'une des revendications 1 à 12, **caractérisé par le fait que** le matériau M2 est à base d'au moins un oxyde métallique, tel qu'un oxyde de Si, Ti, Zr, Al, Zn, Sn, Nb, Sb, Ce, ou d'un vanadate contenant des ions des lanthanides.

14. Substrat revêtu selon l'une des revendications 1 à 13, **caractérisé par le fait que** la couche de matériau M1 a une épaisseur de 50 nm à 5 µm, de préférence de 100 nm à 2 µm et que les pores qu'elle contient présentent une plus grande dimension moyenne de 30 à 600 nm.

15. Substrat revêtu selon l'une des revendications 9 et 11 à 14, **caractérisé par le fait que** les nanoparticules ont une dimension de 5 à 100 nm.

16. Substrat revêtu selon l'une des revendications 10 à 14, **caractérisé par le fait que** la coquille sur toute la surface intérieure des pores a une épaisseur de 2 à 50 nm.

17. Substrat revêtu selon l'une des revendications 1 à 16, **caractérisé par le fait que** le matériau M1 est issu d'un précurseur de SiO₂ hydrolyse et le matériau M2 est TiO₂, la couche poreuse étant une couche anti-reflet à bas indice de réfraction et présentant une fonctionnalité auto-nettoyante.

18. Substrat revêtu selon l'une des revendications 1 à 17, **caractérisé par le fait qu'**il comporte un empilement de couches fonctionnelles dont fait ou font partie la ou les couches fonctionnelles poreuses de matériau inorganique M1 présentant, à la surface d'au moins une partie de ses pores, au moins un matériau inorganique M2 différent de M1, la ou les couches fonctionnelles autres que la ou les couches fonctionnelles poreuses précitées ayant été déposées par voie liquide ou par pulvérisation cathodique, telle que PVD, CVD, ou par pyrolyse liquide.

19. Procédé de fabrication d'un substrat revêtu tel que défini à l'une des revendications 1 à 18, **caractérisé par le fait que**, sur un substrat en verre ou en céramique ou en vitrocéramique, on dépose par voie liquide au moins une couche d'un mélange aqueux de précurseur de matériau inorganique M1 et d'un latex aqueux composite dont les particules sont constituées chacune par un coeur organique présentant en surface un matériau M2, et que l'on chauffe jusqu'à élimination ou élimination substantielle des coeurs organiques et de l'eau présente dans le mélange de précurseur et de latex composite.

20. Procédé selon la revendication 19, **caractérisé par le fait que** l'on utilise, comme précurseur de matériau inorganique M1, une solution sol-gel d'au moins un précurseur d'oxyde métallique et/ou d'au moins un organosilane de formule générale :
RₙSiX₄₋ₙ,
dans laquelle :
- n est égal à 0, 1, 2 ou 3, de préférence est égal à 0 ou 1 ;
- les groupes X, identiques ou différents lorsque n est égal à 0, 1 ou 2, représentent des groupes hydrolysables choisis parmi les groupes alcoxy, acyloxy ou halogénure, de préférence alcoxy ; et
- les groupes R, identiques ou différents lorsque n est égal à 2 ou 3, représentent des groupes organiques ou fonctions organiques non hydrolysables lié(e)s au silicium par un atome de carbone,
le matériau inorganique M1 étant obtenu par durcissement de ladite solution sol-gel, au cours duquel ledit ou lesdits précurseurs d'oxyde métallique et ledit ou lesdits organosilanes subissent une hydrolyse et une condensation.

21. Procédé selon la revendication 19, **caractérisé par le fait qu'**un précurseur d'oxyde métallique est un précurseur d'un oxyde d'un métal choisi parmi Si, Ti, Zr, Al, Zn, Sn, Nb, Sb.

22. Procédé selon la revendication 19, **caractérisé par le fait que** les groupes X sont choisis parmi les groupes alcoxy -O-R', avec R' représentant un groupe alkyle en C₁-C₄, notamment méthoxy ou éthoxy, les groupes acyloxy -O-C(O)R", avec R" représentant un radical alkyle, tel qu'un alkyle en C₁-C₆, notamment méthyle ou éthyle ; les halogénures tels que Cl, Br et I ; et leurs combinaisons.

23. Procédé selon la revendication 19, **caractérisé par le fait que** les groupes R sont choisis parmi les groupes méthyle, glycidyle ou glycidoxypropyle.

24. Procédé selon la revendication 22, **caractérisé par le fait que** l'on utilise le tétraéthoxysilane (TEOS) comme précurseur de matériau inorganique M1.

25. Procédé selon l'une des revendications 19 à 24, **caractérisé par le fait que** l'on prépare le latex aqueux composite en mélangeant un latex dit de base obtenu par polymérisation en émulsion aqueuse d'un polymère ou copolymère P avec une dispersion dans l'eau de nanoparticules de matériau organique M2 dans des conditions d'hétérocoagulation et, avantageusement sous agitation par ultrasons, pour obtenir un latex dit nanocomposite, dont les particules de polymère ou copolymère P constituant lesdits coeurs organiques portent en surface lesdites nanoparticules de matériau M2.

26. Procédé selon l'une des revendications 19 à 24, **caractérisé par le fait que**, dans le cas où le matériau inorganique M2 se présente sous la forme d'une coquille sur toute la surface intérieure des pores d'une couche poreuse, on prépare le latex aqueux composite en mélangeant un latex dit de base obtenu par polymérisation en émulsion aqueuse d'un polymère ou copolymère P avec un précurseur de matériau inorganique M2 en solution, et en ajustant les conditions de réaction pour qu'une réaction de condensation se produise sur toute la surface des particules du latex de base, formant un enrobage desdites particules par le matériau inorganique M2.

27. Procédé selon l'une des revendications 25 et 26, **caractérisé par le fait que** l'on choisit le polymère ou copolymère P parmi le poly(méthacrylate de méthyle), les copolymères méthacrylate de méthyle-acrylate de butyle et le polystyrène.

28. Procédé selon l'une des revendications 19 à 27, **caractérisé par le fait que** l'on utilise un matériau M2 à base d'au moins un oxyde métallique, tel qu'un oxyde de Si, Ti, Zr, Al, Zn, Sn, Nb, Sb, Ce, ou d'un vanadate contenant des ions des lanthanides.

29. Procédé selon l'une des revendications 19 à 28, **caractérisé par le fait que** l'on dépose la couche de mélange par revêtement par centrifugation.

30. Procédé selon l'une des revendications 19 à 29, **caractérisé par le fait que** pour former un empilement de couches, on dépose au moins une autre couche fonctionnelle par voie liquide ou par pulvérisation cathodique, telle que PVD, CVD, ou par pyrolyse liquide, dans l'ordre désiré pour l'empilement de couches.

31. Utilisation du substrat revêtu tel que défini à l'une des revendications 1 à 18 ou fabriqué par le procédé tel que défini à l'une des revendications 19 à 30 comme élément d'un dispositif opto-électronique, tel que module photovoltaïque et dispositif électroluminescent, ou d'un vitrage monolithique ou feuilleté, simple ou multiple, pour le bâtiment et les véhicules de transport.

32. Module photovoltaïque comportant un substrat revêtu tel que défini à l'une des revendications 1 à 18 ou fabriqué par le procédé tel que défini à l'une des revendications 19 à 30 comme verre de recouvrement.

33. Dispositif électroluminescent comportant un substrat revêtu tel que défini à l'une des revendications 1 à 18 ou fabriqué par le procédé tel que défini à l'une des revendications 19 à 30 comme diode organique électroluminescente.

34. Vitrage monolithique ou feuilleté, simple ou multiple, pour le bâtiment et les véhicules de transport, comportant au moins un substrat revêtu tel que défini à l'une des revendications 1 à 18 ou fabriqué par le procédé tel que défini à l'une des revendications 19 à 30 comme vitre ou feuille de verre d'un vitrage multiple.

## Patentansprüche

1. Transparentes Substrat aus Glas oder aus Keramik oder aus Glaskeramik, das mit einer Funktionsschicht oder einem Stapel aus mindestens zwei Funktionsschichten beschichtet ist, wobei die Funktionsschicht oder mindestens die eine der Funktionsschichten des Stapels porös ist und aus einem anorganischen Material M1 besteht, **dadurch gekennzeichnet, dass** die oder mindestens die eine der poröse(n) Funktionsschicht(en) aus anorganischem Material M1, an der Oberfläche mindestens eines Teils ihrer Poren, mindestens ein anorganisches Material M2 aufweist, das von M1 verschieden ist.

2. Beschichtetes Substrat nach Anspruch 1, **dadurch gekennzeichnet, dass** das anorganische Material M2 an der Oberfläche sämtlicher Poren einer porösen Schicht aus anorganischem Material M1 vorhanden ist.

3. Beschichtetes Substrat nach einem der Ansprüche 1 und 2, **dadurch gekennzeichnet, dass** das anorganische Material M1 ein Material ist, das aus dem Härten einer Sol-Gel-Lösung mindestens eines Metalloxidvorläufers und/oder oder mindestens eines Organosilans der allgemeinen Formel
RₙSiX₄₋ₙ
resultiert, worin
- n gleich 0, 1, 2 oder 3 ist, vorzugsweise gleich 0 oder 1 ist;
- die Gruppen X, identisch oder verschieden, wenn n gleich 0, 1 oder 2 ist, hydrolysierbare Gruppen repräsentieren, die aus den Alkoxy-, Acyloxy- oder Halogenid-Gruppen, vorzugsweise Alcoxy-Gruppen, ausgewählt sind; und
- die Gruppen R, identisch oder verschieden, wenn n gleich 2 oder 3 ist, nicht hydrolysierbare organische Gruppen oder organische Funktionen repräsentieren, die an Silizium über ein Kohlenstoffatom gebunden sind, wobei der oder die Metalloxidvorläufer und das oder die Organosilan(e) während ihrer Härtung einer Hydrolyse und einer Kondensation unterzogen wurden.

4. Beschichtetes Substrat nach Anspruch 3, **dadurch gekennzeichnet, dass** ein Metalloxidvorläufer ein Vorläufer eines Oxids eines Metalls ist, das aus Si, Ti, Zr, Al, Zn, Sn, Nb, Sb ausgewählt ist.

5. Beschichtetes Substrat nach Anspruch 3, **dadurch gekennzeichnet, dass** die Gruppen X aus den Alkoxy-Gruppen -O-R', wobei R' eine C₁-C₄-Alkylgruppe repräsentiert, insbesondere Methoxy- oder Ethoxy-Gruppen, den Acyloxy-Gruppen -O-C(O)R", wobei R" ein Alkylradikal repräsentiert, wie ein C₁-C₆-Alkyl, insbesondere Methyl- oder Ethyl-Gruppen; den Halogeniden wie Cl, Br und I; und deren Kombinationen ausgewählt sind.

6. Beschichtetes Substrat nach Anspruch 3, **dadurch gekennzeichnet, dass** die Gruppen R aus den Methyl-, Glycidyl- oder Glycidoxypropyl-Gruppen ausgewählt sind.

7. Beschichtetes Substrat nach einem der Ansprüche 1 bis 6, **dadurch gekennzeichnet, dass** die Poren 5 bis 74 Volumen-% einer porösen Schicht aus anorganischem Material M1 repräsentieren.

8. Beschichtetes Substrat nach einem der Ansprüche 1 bis 7, **dadurch gekennzeichnet, dass** die Poren kugelförmig oder eiförmig sind.

9. Beschichtetes Substrat nach einem der Ansprüche 1 bis 8, **dadurch gekennzeichnet, dass** das anorganische Material M2 die Form von Nanopartikeln aufweist, die an der Oberfläche der Poren des anorganischen Materials M1 adsorbiert sind.

10. Beschichtetes Substrat nach einem der Ansprüche 1 bis 8, **dadurch gekennzeichnet, dass** das anorganische Material M2 über die gesamte innere Oberfläche der Poren die Form einer Schale aufweist.

11. Beschichtetes Substrat nach einem der Ansprüche 1 bis 10, **dadurch gekennzeichnet, dass** das anorganische Material M2 aus einer anorganischen Phase hervorgegangen ist, die in Form von Nanopartikeln in Wasser dispergierbar und an der Partikeloberfläche eines Latex, so genannter Basis-Latex, adsorbierbar ist, insbesondere durch Heterokoagulation und vorteilhafterweise unter Ultraschallschütteln.

12. Beschichtetes Substrat nach einem der Ansprüche 1 bis 11, **dadurch gekennzeichnet, dass** die Nanopartikel des Materials M2 katalytische Nanopartikel, wie photokatalytische und thermokatalytische Nanopartikel, oder Lumineszenzpartikel sind.

13. Beschichtetes Substrat nach einem der Ansprüche 1 bis 12, **dadurch gekennzeichnet, dass** das Material M2 auf Basis mindestens eines Metalloxids, wie ein Si-, Ti-, Zr-, AI-, Zn-, Sn-, Nb-, Sb-, Ce-Oxid, oder eines Vanadats, das Lanthanidionen enthält, ist.

14. Beschichtetes Substrat nach einem der Ansprüche 1 bis 13, **dadurch gekennzeichnet, dass** die Schicht aus Material M1 eine Dicke von 50 nm bis 5 µm, vorzugsweise von 100 nm bis 2 µm hat und dass die Poren, die sie enthält, eine größere mittlere Größe von 30 bis 600 nm haben.

15. Beschichtetes Substrat nach einem der Ansprüche 9 und 11 bis 14, **dadurch gekennzeichnet, dass** die Nanopartikel eine Größe von 5 bis 100 nm haben.

16. Beschichtetes Substrat nach einem der Ansprüche 10 bis 14, **dadurch gekennzeichnet, dass** die Schale über die gesamte Innenfläche der Poren eine Dicke von 2 bis 50 nm hat.

17. Beschichtetes Substrat nach einem der Ansprüche 1 bis 16, **dadurch gekennzeichnet, dass** das Material M1 aus einem hydrolysierten SiO₂-Vorläufer hervorgegangen ist und das Material M2 TiO₂ ist, wobei die poröse Schicht eine Antireflexschicht mit niedrigem Brechungsindex ist und eine Selbstreinigungsfunktionalität aufweist.

18. Beschichtetes Substrat nach einem der Ansprüche 1 bis 17, **dadurch gekennzeichnet, dass** es einen Stapel aus Funktionsschichten aufweist, wovon die poröse(n) Funktionsschicht(en) aus anorganischem Material M1 Teil ist oder sind, die, an der Oberfläche mindestens eines Teils ihrer Poren, mindestens ein anorganisches Material M2 aufweist bzw. aufweisen, das von M1 verschieden ist, wobei die andere(n) Funktionsschicht(en) als die oben genannte(n) poröse(n) Funktionsschicht(en) in flüssiger Form oder durch Kathodenzerstäubung, wie PVD, CVD, oder durch flüssige Pyrolyse abgeschieden worden ist bzw. sind.

19. Verfahren zur Herstellung eines beschichteten Substrats nach einem der Ansprüche 1 bis 18, **dadurch gekennzeichnet, dass** auf einem Substrat aus Glas oder aus Keramik oder aus Glaskeramik in flüssiger Form mindestens eine Schicht aus einem wässrigen Vorläufergemisch eines anorganisches Materials M1 und aus einem wässrigen Verbundlatex abgeschieden wird, dessen Partikel jeder durch einen organischen Kern gebildet sind, der an der Oberfläche ein Material M2 aufweist, und die bis zum Beseitigen oder wesentlichen Beseitigen der organischen Kerne und des in dem Gemisch aus Vorläufer und Verbundlatex vorhandenen Wassers erhitzt wird.

20. Verfahren nach Anspruch 19, **dadurch gekennzeichnet, dass** , als Vorläufer des anorganischen Materials M1, eine Sol-Gel-Lösung mindestens eines Metalloxidvorläufers und/oder mindestens eines Organosilans der allgemeinen Formel
RₙSiX₄₋ₙ
verwendet wird, worin
- n gleich 0, 1, 2 oder 3 ist, vorzugsweise gleich 0 oder 1 ist;
- die Gruppen X, identisch oder verschieden, wenn n gleich 0, 1, 2 oder 3 ist, hydrolysierbare Gruppen repräsentieren, die aus den Alkoxy-, Acyloxy- oder Halogenid-Gruppen, vorzugsweise Alcoxy-Gruppen, ausgewählt sind; und
- die Gruppen R, identisch oder verschieden, wenn n gleich 2 oder 3 ist, nicht hydrolysierbare organische Gruppen oder organische Funktionen repräsentieren, die an Silizium über ein Kohlenstoffatom gebunden sind, wobei das anorganische Material M1 durch Härten der Sol-Gel-Lösung erhalten wird, in dessen Verlauf der oder die Metalloxidvorläufer und das oder die Organosilan(e) einer Hydrolyse und einer Kondensation unterzogen werden.

21. Verfahren nach Anspruch 19, **dadurch gekennzeichnet, dass** ein Metalloxidvorläufer ein Vorläufer eines Oxids eines Metalls ist, das aus Si, Ti, Zr, Al, Zn, Sn, Nb, Sb ausgewählt ist.

22. Verfahren nach Anspruch 19, **dadurch gekennzeichnet, dass** die Gruppen X aus den Alkoxy-Gruppen -O-R', wobei R' eine C₁-C₄-Alkylgruppe repräsentiert, insbesondere Methoxy- oder Ethoxy-Gruppen, den Acyloxy-Gruppen -O-C(O)R", wobei R" ein Alkylradikal repräsentiert, wie ein C₁-C₆-Alkyl, insbesondere Methyl- oder Ethyl-Gruppen; den Halogeniden wie Cl, Br und I; und deren Kombinationen ausgewählt sind.

23. Verfahren nach Anspruch 19, **dadurch gekennzeichnet, dass** die Gruppen R aus den Methyl-, Glycidyl- oder Glycidoxypropyl-Gruppen ausgewählt sind.

24. Verfahren nach Anspruch 22, **dadurch gekennzeichnet, dass** Tetraethoxisilan (TEOS) als Vorläufer des anorganischen Materials M1 verwendet wird.

25. Verfahren nach einem der Ansprüche 19 bis 24, **dadurch gekennzeichnet, dass** der wässrige Verbundlatex hergestellt wird, indem ein Latex, so genannter Basis-Latex, der durch Polymerisation in wässriger Emulsion eines Polymers oder Copolymers P erhalten wird, mit einer Dispersion von Nanopartikeln aus organischem Material M2 in Wasser unter Heterokoagulations-Bedingungen, und vorteilhafterweise unter Ultraschallschütteln, gemischt wird, um einen Latex, so genannten Nanoverbund-Latex, zu erhalten, dessen Partikel aus Polymer oder Copolymer P die organischen Kerne bilden, die an der Oberfläche die Nanopartikel aus Material M2 tragen.

26. Verfahren nach einem der Ansprüche 19 bis 24, **dadurch gekennzeichnet, dass** für den Fall, dass das anorganische Material M2 über die gesamte innere Oberfläche der Poren einer porösen Schicht die Form einer Schale aufweist, der wässrige Verbund-Latex hergestellt wird, indem ein Latex, so genannter Basis-Latex, der durch Polymerisation in wässriger Emulsion eines Polymers oder Copolymers P erhalten wird, mit einem Vorläufer des anorganischen Materials M2 in Lösung gemischt wird und indem die Reaktionsbedingungen angepasst werden, damit eine Kondensationsreaktion auf der gesamten Oberfläche der Partikel des Basis-Latex erfolgt, wodurch eine Ummantelung der Partikel durch das anorganische Material M2 gebildet wird.

27. Verfahren nach einem der Ansprüche 25 und 26, **dadurch gekennzeichnet, dass** das Polymer oder Copolymer P aus Poly(methyl)methacrylat, den Methylmethacrylat-Butylacrylat-Copolymeren und Polystyrol ausgewählt wird.

28. Verfahren nach einem der Ansprüche 19 bis 27, **dadurch gekennzeichnet, dass** ein Material M2 auf Basis mindestens eines Metalloxids, wie ein Si-, Ti-, Zr-, AI-, Zn-, Sn-, Nb-, Sb-, Ce-Oxid, oder eines Vanadats, das Lanthanidionen enthält, verwendet wird.

29. Verfahren nach einem der Ansprüche 19 bis 28, **dadurch gekennzeichnet, dass** die Gemischschicht durch Zentrifugationsbeschichtung abgeschieden wird.

30. Verfahren nach einem der Ansprüche 19 bis 29, **dadurch gekennzeichnet, dass** zum Bilden eines Schichtstapels mindestens eine weitere Funktionsschicht in flüssiger Form oder durch Kathodenzerstäubung, wie PVD, CVD, oder durch flüssige Pyrolyse in der für den Schichtstapel gewünschten Reihenfolge abgeschieden wird.

31. Verwendung des beschichteten Substrats nach einem der Ansprüche 1 bis 18 oder des beschichteten Substrats, das durch das Verfahren nach einem der Ansprüche 19 bis 30 hergestellt ist, als Element einer optoelektronischen Vorrichtung, wie Photovoltaikmodul und Elektrolumineszenzvorrichtung, oder einer monolithischen Verglasung oder Verbundverglasung, einfach oder mehrfach, für Gebäude und Transportfahrzeuge.

32. Photovoltaikmodul mit einem beschichteten Substrat nach einem der Ansprüche 1 bis 18 oder mit einem beschichteten Substrat, das durch das Verfahren nach einem der Ansprüche 19 bis 30 hergestellt ist, als Abdeckglas.

33. Elektrolumineszenzvorrichtung mit einem beschichteten Substrat nach einem der Ansprüche 1 bis 18 oder mit einem beschichteten Substrat, das durch das Verfahren nach einem der Ansprüche 19 bis 30 hergestellt ist, als organische Elektrolumineszenzdiode.

34. Monolithische Verglasung oder Verbundverglasung, einfach oder mehrfach, für Gebäude und Transportfahrzeuge, mit einem beschichteten Substrat nach einem der Ansprüche 1 bis 18 oder mit einem beschichteten Substrat, das durch das Verfahren nach einem der Ansprüche 19 bis 30 hergestellt ist, als Scheibe oder Glasscheibe einer Mehrfachverglasung.

## Claims

1. A transparent glass or ceramic or glass-ceramic substrate, coated with a functional layer or with a stack of at least two functional layers, said functional layer or at least one of said functional layers of the stack being porous and made of an inorganic material M1, **characterized in that** the or at least one of the porous functional layer(s) of inorganic material M1 has, at the surface of at least one portion of the pores thereof, at least one inorganic material M2 different from M1.

2. The coated substrate as claimed in claim 1, **characterized in that** the inorganic material M2 is present at the surface of all the pores of a porous layer of inorganic material M1.

3. The coated substrate as claimed in either of claims 1 and 2, **characterized in that** the inorganic material M1 is a material that results from the curing of a sol-gel solution of at least one metal oxide precursor and/or of at least one organosilane of general formula:
RₙSiX₄₋ₙ,
wherein:
- n is equal to 0, 1, 2 or 3, preferably is equal to 0 or 1;
- the X groups, which may be identical or different when n is equal to 0, 1 or 2, represent hydrolyzable groups selected from alkoxy, acyloxy or halide groups, preferably alkoxy groups; and
- the R groups, which may be identical or different when n is equal to 2 or 3, represent non-hydrolyzable organic groups or organic functions bonded to the silicon via a carbon atom,
said metal oxide precursor(s) and said organosilane(s) having undergone a hydrolysis and a condensation during said curing.

4. The coated substrate as claimed in claim 3, **characterized in that** a metal oxide precursor is a precursor of an oxide of a metal selected from Si, Ti, Zr, Al, Zn, Sn, Nb, Sb.

5. The coated substrate as claimed in claim 3, **characterized in that** the X groups are selected from -O-R' alkoxy groups, with R' representing a C₁-C₄ alkyl group, in particular methoxy or ethoxy groups, -O-C(O)R" acyloxy groups, with R" representing an alkyl radical, such as a C₁-C₆ alkyl, in particular methyl or ethyl; halides such as Cl, Br and I; and combinations thereof.

6. The coated substrate as claimed in claim 3, **characterized in that** the R groups are selected from methyl, glycidyl or glycidoxypropyl groups.

7. The coated substrate as claimed in one of claims 1 to 6, **characterized in that** the pores represent 5% to 74% by volume of a porous layer of inorganic material M1.

8. The coated substrate as claimed in one of claims 1 to 7, **characterized in that** the pores are of spherical or ovoid shape.

9. The coated substrate as claimed in one of claims 1 to 8, **characterized in that** the inorganic material M2 is in the form of nanoparticles adsorbed at the surface of the pores of the inorganic material M1.

10. The coated substrate as claimed in one of claims 1 to 8, **characterized in that** the inorganic material M2 is in the form of a coating over the entire inner surface of the pores.

11. The coated substrate as claimed in one of claims 1 to 10, **characterized in that** the inorganic material M2 is derived from an inorganic phase that can be dispersed in the form of nanoparticles in water and that can be adsorbed at the surface of particles of a latex, referred to as base latex, in particular by heterocoagulation and advantageously with ultrasonic agitation.

12. The coated substrate as claimed in one of claims 1 to 11, **characterized in that** the nanoparticles of the material M2 are catalytic nanoparticles, such as photocatalytic and thermocatalytic nanoparticles, or luminescent particles.

13. The coated substrate as claimed in one of claims 1 to 12, **characterized in that** the material M2 is based on at least one metal oxide, such as an oxide of Si, Ti, Zr, Al, Zn, Sn, Nb, Sb, Ce, or on a vanadate containing lanthanide ions.

14. The coated substrate as claimed in one of claims 1 to 13, **characterized in that** the layer of material M1 has a thickness of from 50 nm to 5 µm, preferably from 100 nm to 2 µm and that the pores that it contains have a mean largest dimension of from 30 to 600 nm.

15. The coated substrate as claimed in one of claims 9 and 11 to 14, **characterized in that** the nanoparticles have a dimension of from 5 to 100 nm.

16. The coated substrate as claimed in one of claims 10 to 14, **characterized in that** the coating of the inner surface of the pores has a thickness of from 2 to 50 nm.

17. The coated substrate as claimed in one of claims 1 to 16, **characterized in that** the material M1 is derived from a hydrolyzed SiO₂ precursor and the material M2 is TiO₂, the porous layer being an antireflection layer with a low refractive index and that has a self-cleaning functionality.

18. The coated substrate as claimed in one of claims 1 to 17, **characterized in that** it comprises a stack of functional layers of which the porous functional layer(s) of inorganic material M1 having, at the surface of at least one portion of the pores thereof, at least one inorganic material M2 different from M1 are part, the functional layer(s) other than the aforementioned porous functional layer(s) having been deposited by a liquid method or by sputtering, such as PVD, CVD, or by liquid pyrolysis.

19. A process for manufacturing a coated substrate as defined in one of claims 1 to 18, **characterized in that**, deposited by a liquid method on a glass or ceramic or glass-ceramic substrate is at least one layer of an aqueous mixture of inorganic material M1 precursor and of a composite aqueous latex, the particles of which each consist of an organic core having a material M2 at the surface, and that heating is applied until the organic cores and water present in the mixture of precursor and of composite latex are eliminated or substantially eliminated.

20. The process as claimed in claim 19, **characterized in that** use is made, as inorganic material M1 precursor, of a sol-gel solution of at least one metal oxide precursor and/or of at least one organosilane of general formula:
RₙSiX₄₋ₙ,
wherein:
- n is equal to 0, 1, 2 or 3, preferably is equal to 0 or 1;
- the X groups, which may be identical or different when n is equal to 0, 1 or 2, represent hydrolyzable groups selected from alkoxy, acyloxy or halide groups, preferably alkoxy groups; and
- the R groups, which may be identical or different when n is equal to 2 or 3, represent non-hydrolyzable organic groups or organic functions bonded to the silicon via a carbon atom,
the inorganic material M1 being obtained by curing said sol-gel solution, during which said metal oxide precursor(s) and said organosilane(s) undergo a hydrolysis and a condensation.

21. The process as claimed in claim 19, **characterized in that** a metal oxide precursor is a precursor of an oxide of a metal selected from Si, Ti, Zr, Al, Zn, Sn, Nb, Sb.

22. The process as claimed in claim 19, **characterized in that** the X groups are selected from -O-R' alkoxy groups, with R' representing a C₁-C₄ alkyl group, in particular methoxy or ethoxy groups, -O-C(O)R" acyloxy groups, with R" representing an alkyl radical, such as a C₁-C₆ alkyl, in particular methyl or ethyl; halides such as Cl, Br and I; and combinations thereof.

23. The process as claimed in claim 19, **characterized in that** the R groups are selected from methyl, glycidyl or glycidoxypropyl groups.

24. The process as claimed in claim 22, **characterized in that** use is made of tetraethoxysilane (TEOS) as inorganic material M1 precursor.

25. The process as claimed in one of claims 19 to 24, **characterized in that** the composite aqueous latex is prepared by mixing a base latex obtained by aqueous emulsion polymerization of a polymer or copolymer P with a dispersion in water of nanoparticles of organic material M2 under heterocoagulation conditions, and advantageously with ultrasonic agitation, in order to obtain a nanocomposite latex, of which the polymer or copolymer P particles constituting said organic cores bear at the surface said nanoparticles of material M2.

26. The process as claimed in one of claims 19 to 24, **characterized in that**, in the case where the inorganic material M2 is in the form of a shell over the entire inner surface of the pores of a porous layer, the composite aqueous latex is prepared by mixing a base latex obtained by aqueous emulsion polymerization of a polymer or copolymer P with an inorganic material M2 precursor in solution, and by adjusting the reaction conditions so that a condensation reaction takes place over the entire surface of the particles of the base latex, forming a covering of said particles with the inorganic material M2.

27. The process as claimed in either of claims 25 and 26, **characterized in that** the polymer or copolymer P is selected from poly(methyl methacrylate), methyl methacrylate/butyl acrylate copolymers and polystyrene.

28. The process as claimed in one of claims 19 to 27, **characterized in that** use is made of a material M2 based on at least one metal oxide such as an oxide of Si, Ti, Zr, Al, Zn, Sn, Nb, Sb, Ce, or on a vanadate containing lanthanide ions.

29. The process as claimed in one of claims 19 to 28, **characterized in that** the layer of mixture is deposited by spin coating.

30. The process as claimed in one of claims 19 to 29, **characterized in that** in order to form a stack of layers, at least one other functional layer is deposited by a liquid method or by sputtering, such as PVD, CVD, or by liquid pyrolysis, in the order desired for the stack of layers.

31. The use of the coated substrate as defined in one of claims 1 to 18 or manufactured by the process as defined in one of claims 19 to 30 as an element of an optoelectronic device, such as photovoltaic module and light-emitting device, or of a single or multiple, monolithic or laminated glazing unit for buildings and transport vehicles.

32. A photovoltaic module comprising a coated substrate as defined in one of claims 1 to 18 or manufactured by the process as defined in one of claims 19 to 30 as cover glass.

33. A light-emitting device comprising a coated substrate as defined in one of claims 1 to 18 or manufactured by the process as defined in one of claims 19 to 30 as organic light-emitting diode.

34. A single or multiple, monolithic or laminated glazing unit for buildings and transport vehicles, comprising at least one coated substrate as defined in one of claims 1 to 18 or manufactured by the process as defined in one of claims 19 to 30 as pane or sheet of glass of a multiple glazing unit.
